(19) Europäisches Patentamt / European Patent Office / Office européen des brevets

(11) **EP 2 616 516 B1**

(12) **FASCICULE DE BREVET EUROPEEN**

(45) Date de publication et mention
de la délivrance du brevet:
**08.07.2015 Bulletin 2015/28**

(51) Int Cl.:
*C09D 11/0235* (2014.01)   *C09D 11/037* (2014.01)
*H01M 4/86* (2006.01)   *H01M 4/88* (2006.01)
*H01M 8/12* (2006.01)   *C09D 11/52* (2014.01)
*H05K 1/09* (2006.01)

(21) Numéro de dépôt: **11755381.8**

(22) Date de dépôt: **28.07.2011**

(86) Numéro de dépôt international:
**PCT/FR2011/051828**

(87) Numéro de publication internationale:
**WO 2012/035226 (22.03.2012 Gazette 2012/12)**

(54) **ENCRE AQUEUSE POUR LA REALISATION D'ELECTRODES DE CELLULE ELECTROCHIMIQUE HAUTE TEMPERATURE**

WÄSSRIGE TINET FÜR DIE HERSTELLUNG VON ELEKTRODEN ELEKTROCHEMISCHER ZELLEN

AQUEOUS INK FOR THE PRODUCTION OF HIGH TEMPERATURE ELECTROCHEMICAL CELL ELECTRODES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.09.2010 FR 1057247**

(43) Date de publication de la demande:
**24.07.2013 Bulletin 2013/30**

(73) Titulaire: **Commissariat à l'Énergie Atomique et aux Énergies Alternatives
75015 Paris (FR)**

(72) Inventeur: **LAUCOURNET, Richard
F-38500 La Buisse (FR)**

(74) Mandataire: **Cabinet Laurent & Charras
Le Contemporain
50 Chemin de la Bruyère
69574 Dardilly Cedex (FR)**

(56) Documents cités:
**WO-A1-2004/063295   WO-A2-2004/040627
WO-A2-2006/066973   US-A1- 2003 224 240**

• **TOMOV R I ET AL: "Direct ceramic inkjet printing of yttria-stabilized zirconia electrolyte layers for anode-supported solid oxide fuel cells", JOURNAL OF POWER SOURCES, ELSEVIER SA, CH, vol. 195, no. 21, 1 novembre 2010 (2010-11-01), pages 7160-7167, XP027134870, ISSN: 0378-7753 [extrait le 2010-07-09]**

**Description**

**DOMAINE DE L'INVENTION**

L'invention concerne une encre aqueuse pour l'élaboration d'électrodes de cellule électrochimique fonctionnant à haute température. Cette encre aqueuse comprend une charge minérale, un liant et un dispersant.

Le domaine d'application concerne notamment la fabrication, par sérigraphie, de composants céramiques pour des cellules électrochimiques destinées aux applications à haute température des piles à combustible (SOFC, pile à combustible à oxyde solide ou *"solid oxide fuel cell"* en anglais) et de l'électrolyse de la vapeur d'eau à haute température (EHT ou SOEC *"solid oxide electrolyser cell"* en anglais).

**ETAT ANTERIEUR DE LA TECHNIQUE**

Les cellules électrochimiques céramiques dédiées aux applications de hautes températures (600-1.000°C) peuvent présenter une configuration dite à électrolyte support *("electrolyte supported cell"* en anglais). Dans ce mode de réalisation, l'électrolyte épais (120-200 micromètres) remplit également la fonction de support mécanique de l'ensemble de la cellule ; les électrodes (anode et cathode) étant généralement disposées de part et d'autre de l'électrolyte selon le concept suivant :

-   électrolyte en zircone stabilisée à l'oxyde d'yttrium (YSZ) ;
-   électrode dite à hydrogène (anode en utilisation SOFC ou cathode en EHT) comportant un mélange de zircone stabilisée à l'oxyde d'yttrium (YSZ) ou de cérine substituée à l'oxyde d'yttrium (CYO) ou de gadolinium (CGO) et d'oxyde de nickel (NiO). L'oxyde de nickel est réduit au démarrage de la cellule pour former du nickel métallique et ainsi constituer un cermet (matériau composite fritté composé d'au moins un métal et un produit céramique) ;
-   électrode à air (cathode en utilisation SOFC ou anode en EHT) comportant typiquement un mélange de zircone stabilisée à l'oxyde d'yttrium (YSZ) et de manganite de lanthane dopée au strontium (LSM).

En général, les électrodes comportent (a) une couche dite fonctionnelle où a lieu la réaction électrochimique et (b) une couche dite collectrice chargée d'assurer la collecte (en mode SOFC) ou l'alimentation du courant (en mode EHT).

Ce procédé de fabrication de cellule électrochimique a notamment été décrit par Huijsmans et al. (Fuel Cells Bulletin, Volume 2, Issue 14. November 1999, Pages 5-7). L'électrolyte est tout d'abord mis en forme par coulage en bande avant d'être fritté (densifié) à 1.500°C. Son épaisseur peut varier de 80 à 250 micromètres. Ensuite, les deux électrodes d'épaisseur inférieure ($\approx$50 $\mu$m) sont déposées de part et d'autre de l'électrolyte par sérigraphie, et frittées simultanément à une température comprise entre 1.200 et 1.300°C.

D'autres procédés de mise en forme en couche mince (quelques dizaines de microns) ont été décrits. Il s'agit notamment de la pulvérisation de suspension, du dépôt à la tournette (« *spin coating* ») ou de l'enduction de suspension. Ces procédés demandent une encre ou une suspension céramique contenant les matériaux d'électrodes sous forme de poudre. Selon ces modes de réalisation, les formulations des suspensions ou encres céramiques sont généralement composées de :

-   la charge minérale : LSM, mélange LSM/YSZ, NiO, mélange NiO/YSZ (ou bien CYO, CGO), YSZ (ou bien CYO, CGO) ;
-   un solvant organique : terpinéol, alcool, butanone ;
-   un liant organique chargé de l'adhésion entre les particules céramiques composant les électrodes et l'électrolyte avant le frittage : éthyle cellulose, polyvinyl butyral.

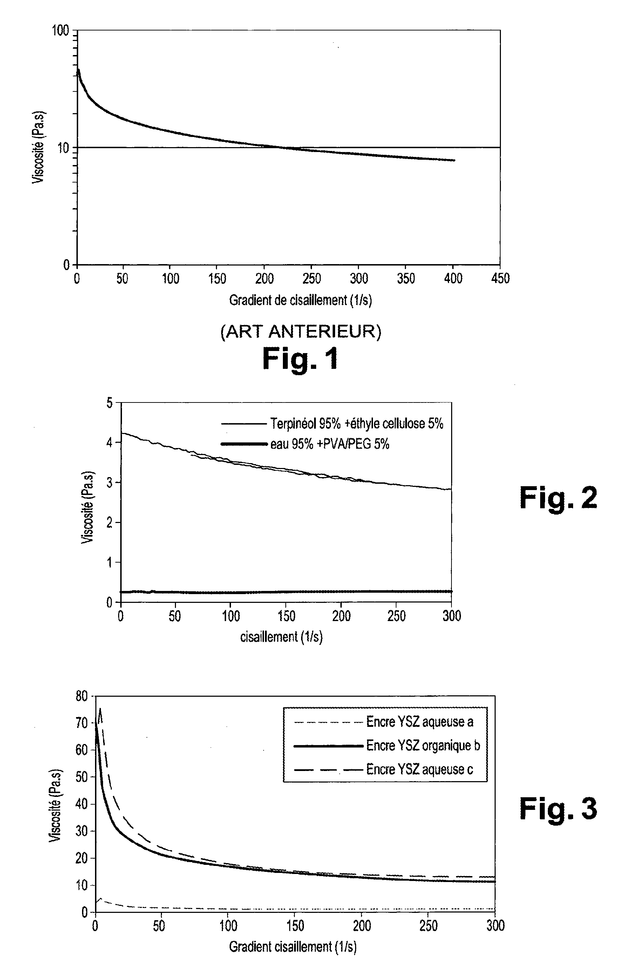

La qualité d'impression d'électrode par sérigraphie dépend du comportement rhéologique de l'encre. L'encre doit notamment présenter un comportement rhéofluidifiant ou pseudoplastique, c'est-à-dire une viscosité infinie en l'absence de cisaillement afin d'éviter l'écoulement après impression et une viscosité faible en présence de cisaillement pour faciliter le passage de l'encre au travers de l'écran d'impression (figure 1).

Typiquement, pour une impression de bonne qualité, la viscosité de l'encre doit être comprise entre 3 et 20 Pa.s au cisaillement imposé par la sérigraphieuse (40 à 700s$^{-1}$). Ainsi l'électrode présente des avantages parmi lesquels on peut noter l'absence de défaut de surface (épaisseur homogène), un décollement écran-substrat aisé (absence de bulles) et l'absence d'étalement de l'encre après impression.

Cependant, indépendamment de la formulation organique, la phase de séchage provoque la volatilisation totale des solvants et donc l'émission de vapeurs irritantes. A l'échelle d'une production industrielle, des tonnes de vapeur peuvent être émises, nécessitant la mise en place d'une installation de collecte et de condensation des vapeurs pour une réutilisation ultérieure éventuelle.

Les procédés de fabrication d'électrodes impliquant l'utilisation d'encres organiques, comme décrits dans le document WO2006/066973, présentent donc des inconvénients non négligeables liés notamment à l'emploi de solvants organiques.

L'utilisation d'encres aqueuses comprenant la même quantité de charge minérale que les encres organiques de l'art antérieur s'est jusqu'à présent heurté principalement à l'incompatibilité entre la viscosité de ladite encre aqueuse et le dépôt par sérigraphie.

Le Demandeur a néanmoins mis au point une encre aqueuse présentant un comportement rhéologique comparable à celui d'une encre organique sans pour autant modifier significativement le taux de charge. De plus, la dispersion de la charge minérale est améliorée en phase aqueuse par rapport aux solvants organiques. L'encre aqueuse selon la présente invention permet en outre d'éviter d'avoir recours à des installations de captation des vapeurs et de condensation des solvants organiques sans altérer les performances des composants de cellule.

## EXPOSE DE L'INVENTION

La présente invention concerne une encre aqueuse présentant une viscosité et une quantité de charge minérale comparables à celles des encres organiques de l'art antérieur. Ainsi, l'épaisseur de la couche déposée, celle-ci étant directement proportionnelle au taux de charge, est maintenue. De plus, la nature de cette encre aqueuse permet également de simplifier sa préparation, sa mise en oeuvre ainsi que son séchage lors de la fabrication d'électrodes.

Plus précisément, la présente invention concerne une encre aqueuse pour électrodes et/ou électrolyte de cellule électrochimique haute température, ladite encre comprenant :

- des particules d'au moins une charge minérale,
- au moins un liant, et
- au moins un dispersant choisi dans le groupe comprenant l'acide chlorhydrique, l'acide sulfurique, ou des polyélectrolytes telles que le citrate d'ammonium et les carboxylates d'ammonium.

La charge minérale, ou matériau actif d'électrode, permet notamment de conduire l'électricité et assure les réactions électrochimiques. La charge minérale est généralement un oxyde métallique et elle peut être plus particulièrement choisie dans le groupe comprenant les oxydes de métaux de transition et de terres rares, et leurs mélanges. Encore plus avantageusement, la charge minérale est choisie dans le groupe comprenant LSM (manganite de lanthane dopée au strontium), YSZ (zircone stabilisée à l'oxyde d'yttrium), NiO (oxyde de nickel), CYO (cérine substituée à l'oxyde d'yttrium), CGO (cérine substituée à l'oxyde de gadolinium) le mélange LSM/YSM, le mélange YSZ/NiO, et leurs mélanges.

De manière avantageuse, la charge minérale représente de 10 à 30 % en volume par rapport au volume de l'encre aqueuse, plus avantageusement de 15 à 25 %vol.

Typiquement, le diamètre des particules de charge minérale est tel que $d_{50} < 10$ micromètres et $d_{90} < 50$ micromètres. Le terme "$d_{50} < 10$ micromètres" signifie que 50% des particules de charge minérale présentent un diamètre inférieur à 10 micromètres alors que "$d_{90} < 50$ micromètres" signifie que 90 % desdites particules présentent un diamètre inférieur à 50 micromètres.

De manière encore plus avantageuse, $d_{50} < 1$ micromètre et $d_{90} < 2$ micromètres.

De manière avantageuse, la surface spécifique des particules de charge minérale est inférieure à 20 $m^2/g$.

Le liant de l'encre aqueuse selon la présente invention assure la cohésion du dépôt et l'adhésion entre les particules et l'électrolyte avant frittage dans le cas de la fabrication d'une électrode. De manière générale, il diffère de celui des encres organiques de l'art antérieur eu égard la nature du solvant (eau).

Le liant peut être avantageusement choisi dans le groupe comprenant PVA (alcool polyvinylique), PEG (polyéthylène glycol), les polyacrylates, les celluloses et de manière générale tous les polymères solubles dans l'eau, et leurs mélanges.

Selon un mode de réalisation préféré, le liant est un mélange PVA/PEG. L'homme du métier saura ajuster le ratio PVA/PEG en fonction des autres composants de l'encre aqueuse et de la viscosité de l'encre souhaitée. De manière avantageuse, le mélange PVA/PEG est tel que le PVA représente 80 à 100% en poids du poids du mélange PVA/PEG, et plus avantageusement 95 à 99% pds.

La quantité de liant et/ou la nature du liant sont ajustées afin d'obtenir une encre aqueuse présentant un comportement rhéologique comparable à celui d'une encre organique sans pour autant modifier le taux de charge minérale. De manière générale, le volume représenté par la quantité de liant ne doit pas être supérieur au volume poreux désiré à l'issue du traitement thermique de frittage de l'électrode. Avantageusement, le liant représente de 20 à 50% du volume par rapport au volume de l'encre aqueuse, et plus avantageusement entre 25 et 35 %vol.

L'encre aqueuse selon la présente invention comporte également au moins un dispersant. Il permet de charger électriquement la surface des particules d'oxyde et d'assurer ainsi une bonne qualité de dispersion par répulsion électrostatique avec une très bonne stabilité dans le temps. Le dispersant peut être avantageusement choisi dans le groupe comprenant l'acide chlorhydrique, l'acide sulfurique, ou des polyélectrolytes tels que le citrate d'ammonium et les carboxylates d'ammonium. De manière encore plus avantageuse, le dispersant est le citrate d'ammonium.

De manière avantageuse, le pourcentage de dispersant est compris entre 0.05 et 1 % en poids par rapport au poids de la charge minérale, et plus avantageusement entre 0.3 et 0.7 % pds.

Dans un mode de réalisation particulier de l'invention, l'encre aqueuse comprend un mélange d'alcool polyvinylique (PVA) et de polyéthylène glycol (PEG) en tant que liant, et du citrate d'ammonium en tant que dispersant.

De manière avantageuse, la viscosité de l'encre aqueuse selon l'invention est comprise entre 1 et 60 Pa.s au cisaillement d'impression. L'homme du métier saura ajuster la composition de l'encre afin d'obtenir la viscosité voulue en modulant le taux de charge et/ou la quantité de liant(s).

Typiquement, la préparation de l'encre aqueuse selon l'invention comprend les étapes suivantes :

- mise en solution d'au moins un dispersant en faible concentration, de préférence de 0,05 à 1% en poids par rapport au poids de la charge minérale ;
- ajout d'au moins une charge minérale et désagglomération par un broyage mécanique, de préférence à l'aide d'un broyeur à boulet, ou d'un broyeur tricylindre, ou d'un disperseur planétaire ;
- ajout d'au moins un liant en solution et mélange.

De manière générale, l'encre aqueuse selon la présente invention peut également être utilisée pour élaborer des composants (électrodes et électrolyte) de cellules de configuration électrode support (*"anode supported cell"* en anglais) ou interconnecteur support (*"metal supported cell"* en anglais).

La présente invention concerne également (a) l'utilisation de l'encre aqueuse telle que décrite ci-dessus pour la fabrication d'un électrolyte et pour la fabrication d'une électrode de cellule électrochimique, (b) les procédés de réalisation associés, ainsi que (c) l'électrode et l'électrolyte obtenus selon les procédés de réalisation respectifs.

Dans le cas des cellules à électrode support ou à métal support, l'électrolyte selon la présente invention peut être obtenu un procédé comprenant le dépôt, avantageusement par sérigraphie, de l'encre aqueuse décrite ci-dessus. Selon un mode de réalisation particulier, l'électrolyte est en YSZ.

Le procédé de réalisation de l'électrode selon l'invention comprend notamment les étapes suivantes :

- dépôt d'une première encre aqueuse selon l'invention, avantageusement par sérigraphie, de manière à former la couche fonctionnelle ;
- dépôt d'une deuxième encre aqueuse selon l'invention, avantageusement par sérigraphie, sur la couche fonctionnelle, de manière à former la couche collectrice ;
- frittage de l'électrode.

Dans le cas d'une électrode à hydrogène contenant du NiO, la couche fonctionnelle est déposée sur une couche d'accroche, elle-même avantageusement préparée par dépôt préalable d'une encre aqueuse selon l'invention sur l'électrolyte. Dans le cas d'une électrode à air, la couche fonctionnelle est déposée directement sur l'électrolyte.

La présente invention concerne également une électrode susceptible d'être obtenue selon le procédé décrit ci-avant. Ladite électrode peut être une électrode à air ou à hydrogène.

L'homme du métier saura ajuster la composition de l'encre aqueuse selon le type d'électrode et/ou d'électrolyte envisagé.

De manière avantageuse, une électrode à air selon l'invention comprend :

- une couche fonctionnelle, obtenue par dépôt d'une encre aqueuse comprenant avantageusement un mélange de LSM/YSZ, ledit dépôt étant effectué sur un électrolyte dense avantageusement en YSZ ;
- une couche conductrice, avantageusement obtenue par dépôt d'une encre aqueuse comprenant du LSM.

De manière avantageuse, une électrode à hydrogène selon l'invention comprend :

- une couche d'accroche, obtenue par dépôt d'une encre aqueuse comprenant avantageusement du YSZ, ledit dépôt étant effectué sur un électrolyte dense avantageusement en YSZ ;
- une couche fonctionnelle, avantageusement obtenue par dépôt d'une encre aqueuse comprenant un mélange de NiO/YSZ ;
- une couche conductrice, avantageusement obtenue par dépôt d'une encre aqueuse comprenant du NiO.

Dans le cadre de la présente invention, le dépôt d'encre aqueuse est généralement réalisé par sérigraphie lors de la fabrication d'électrodes.

Typiquement pour une cellule de type électrolyte support, l'épaisseur de l'électrolyte est comprise entre 80 et 200 micromètres alors que l'épaisseur des différentes couches collectrice, fonctionnelle et d'accroche varie de 5 à 50 micromètres.

La présente invention concerne également une cellule électrochimique comprenant au moins une électrode et/ou un électrolyte tels que décrits ci-dessus.

Dans un mode de réalisation bien particulier, la cellule électrochimique selon l'invention comprend :

- un électrolyte selon l'invention, avantageusement en zircone stabilisée à l'oxyde d'yttrium (YSZ) ;
- une électrode à hydrogène selon l'invention comportant préférentiellement un mélange de zircone stabilisé à l'oxyde d'yttrium (YSZ) ou de cérine substituée à l'oxyde d'yttrium (CYO) ou de gadolinium (CGO) et d'oxyde de nickel (NiO) ;
- une électrode à air selon l'invention comportant préférentiellement un mélange de zircone stabilisée à l'oxyde d'yttrium (YSZ) et de manganite de lanthane dopée au strontium (LSM).

BREVE DESCRIPTION DES FIGURES

L'invention et les avantages qui en découlent ressortiront mieux des figures et exemples suivants.

La figure 1 montre le rhéogramme typique d'une encre céramique (LSM) pour sérigraphie.
La figure 2 montre le comportement rhéologique d'un solvant organique (terpinéol 95%+ éthyle cellulose 5%) et celui d'un solvant aqueux (eau 95% +PVA/PEG 5%).
La figure 3 montre les rhéogrammes typiques d'encres organiques et aqueuses de YSZ pour sérigraphie.
La figure 4 montre le spectre d'impédance caractéristique d'une électrode.
La figure 5 montre le comportement rhéologique typique d'encres organiques de LSM/YSZ et LSM pour sérigraphie.
La figure 6 illustre la microstructure typique d'une électrode à air à base de LSM élaborée à partir d'encres organiques et calcinée à 1.050°C pendant 3 heures sous air.
La figure 7 montre le comportement rhéologique d'encres aqueuses de LSM/YSZ et LSM.
La figure 8 illustre la microstructure d'une électrode à air à base de LSM élaborée à partir d'encres aqueuses et calcinée à 1.050°C pendant 3 heures sous air.
La figure 9 montre la comparaison des spectres d'impédance obtenus à partir d'électrodes à base de LSM élaborées respectivement à l'aide d'encres organiques et aqueuses.
La figure 10 montre la comparaison des résistances de polarisation en fonction de la température d'électrodes à base de LSM élaborées respectivement à l'aide d'encres organiques et aqueuses.
La figure 11 montre le comportement rhéologique typique d'encres organiques de YSZ, YSZ/NiO et NiO.
La figure 12 illustre la microstructure typique d'une électrode à hydrogène à base de YSZ et NiO élaborée à partir d'encres organiques et calcinée à 1200°C pendant 3 heures sous air.
La figure 13 illustre le comportement rhéologique d'encres aqueuses de YSZ, YSZ/NiO et NiO.
La figure 14 illustre la microstructure d'une électrode à hydrogène à base de YSZ et NiO élaborée à partir d'encres aqueuses et calcinée à 1200°C pendant 3 heures sous air.
La figure 15 montre la comparaison des spectres d'impédance obtenus à partir d'électrodes à base de YSZ et NiO élaborées respectivement à l'aide d'encres organiques et aqueuses.
La figure 16 montre la comparaison des résistances de polarisation en fonction de la température d'électrodes à base de YSZ et NiO élaborées respectivement à l'aide d'encres organiques et aqueuses.

**EXEMPLES DE REALISATION DE L'INVENTION**

Une solution organique (terpinéol par exemple) et une solution aqueuse contenant la même quantité de liant ne présentent pas la même viscosité (figure 2). Afin d'obtenir une viscosité voisine, les proportions respectives de solvant/liant/charge minérale sont donc ajustées. En effet, une composition consistant en 77,4% vol de solvant organique, 19,3% vol de charge minérale et 3,3% vol de liant donne une encre organique (encre b) compatible avec les techniques d'impression. En revanche, l'encre aqueuse (encre a) correspondante n'est pas adaptée à l'impression d'électrodes (tableau 1 et figure 3). L'augmentation du taux de charge à 30 % permet d'obtenir un comportement rhéologique comparable à celui de l'encre organique. Cependant, l'encre obtenue alors (encre c) présente un séchage trop rapide et fait donc preuve d'instabilité dans le temps, compromettant ainsi son utilisation pour l'impression par sérigraphie.

Les compositions des encres à base de zircone yttriée (YSZ), dont les rhéogrammes sont reportés sur la figure 3, sont présentées dans le tableau 1.

Tableau 1 : Composition des encres de YSZ (figure 3).

| Référence encre | Nature de l'encre | %vol. YSZ | %vol. solvant | %vol. liant | Commentaires |
|---|---|---|---|---|---|
| YSZ aqueuse a | Aqueuse | 19,3% | 77,4% (Eau) | 3,3% (Alcool polyvinylique) | Ecoulement après impression |
| YSZ organique b | Organique | 19,3% | 77,4% (Terpinéol) | 3,3% Ethyle cellulose) | Pas d'écoulement après impression. Séchage lent |
| YSZ aqueuse c | Aqueuse | 26,7% | 70,0% (Eau) | 3,3% (Alcool polyvinylique) | Pas d'écoulement après impression. Séchage trop rapide |

Les exemples 1 et 2 concernent des encres aqueuses et organiques, leur utilisation pour fabriquer des électrodes à air et à hydrogène ainsi que les cellules électrochimiques comprenant lesdites électrodes. Les exemples 1 et 2 ont été réalisés à partir de particules de charge minérale dont le $d_{50}$ est inférieur à 2 micromètres et présentent une surface spécifiques inférieure à 20 m2/g.

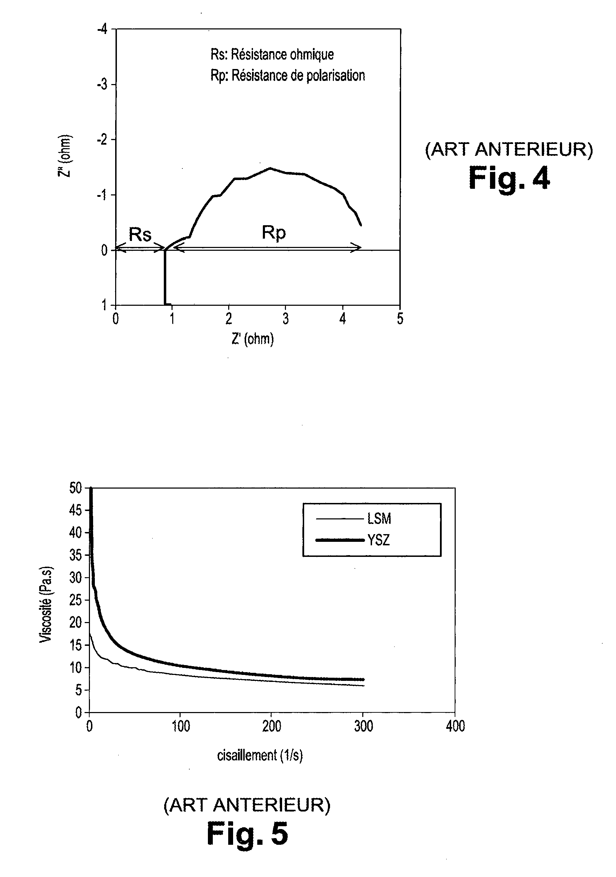

Les performances électrochimiques individuelles des électrodes sont évaluées au moyen de la spectroscopie d'impédance complexe à partir de cellules dites symétriques, comprenant de part et d'autre d'un électrolyte les mêmes électrodes. Cette technique permet, à partir d'un spectre d'impédance et en fonction de la température, de mesurer les résistances caractéristiques des électrodes dans une atmosphère représentative de leur fonctionnement. Pour chacune des électrodes, une résistance purement ohmique (Rs) et une résistance de polarisation (Rp) caractéristique de la réaction électrochimique se produisant à l'électrode sont mesurées (figure 4). A titre d'exemple, les caractéristiques électrochimiques d'électrodes composites à base de LSM/YSZ et NiO/YSZ sont récapitulées dans le tableau 2.

Tableau 2 : Résistances de polarisation d'électrodes élaborées par sérigraphie d'encres organiques (art antérieur).

| Electrode | Rp (omh.cm$^2$) | Température (°C) |
|---|---|---|
| Composite Ni/YSZ Electrode à $H_2$ | 0,50 | 1000 |
| | 0,64 | 850 |
| | 1,12 | 800 |
| | 1,51 | 750 |
| Composite LSM/YSZ Electrode à air | 0,04 | 950 |
| | 0,08 | 900 |
| | 0,19 | 850 |
| | 0,37 | 800 |

Exemple 1 : Electrode composite à air à base de LSM/YSZ.

a) Encres organiques (art antérieur) :

Une cellule dite symétrique est préparée à l'aide de deux encres organiques ayant une composition selon le tableau 3.

Tableau 3 : Composition des encres organiques à base de LSM (art antérieur).

| Référence de l'encre | %vol. charge minérale | %vol. terpinéol | %vol. éthyle cellulose | Viscosité [i] (Pa.s) |
|---|---|---|---|---|
| LSM/YSZ 50/50% pds | 19,3% | 77,4% | 3,3% | 8 |
| LSM | 19,3% | 77,4% | 3,3% | 6,5 |
| [i] Viscosité mesurée au cisaillement de l'impression (250s$^{-1}$) (figure 5) | | | | |

Le cisaillement lors de l'impression par sérigraphie peut être calculé à partir des caractéristiques de l'écran, à savoir le diamètre du fil (e) et la distance entre fils (d) ainsi qu'à partir de certains paramètres de la machine (vitesse d'avance de la racle d'impression (v)) selon la formule suivante :

$$Cisaillement\ (s^{-1})=2*e*v/d^2$$

L'encre à base LSM/YSZ est déposée de manière symétrique (2 faces) sur un électrolyte dense de YSZ avec une épaisseur de 30 micromètres par sérigraphie pour élaborer la couche fonctionnelle de l'électrode.

L'encre à base LSM est déposée de la même manière sur les couches fonctionnelles avec une épaisseur de 15 micromètres par sérigraphie pour élaborer la couche collectrice de l'électrode.

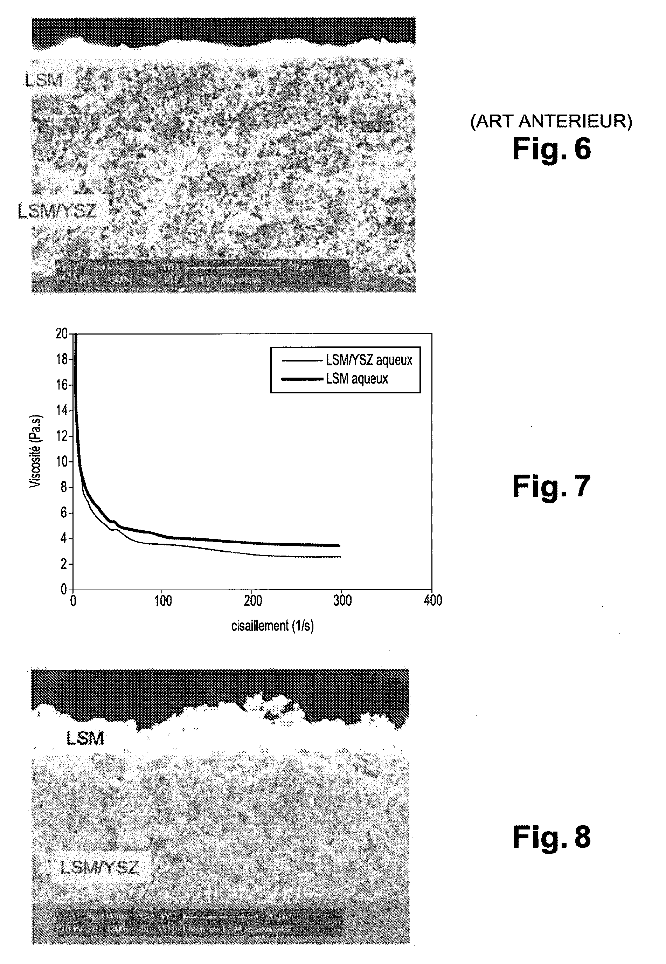

Cette cellule dite « symétrique » est calcinée à 1.050°C pendant 3 heures sous air et caractérisée par spectroscopie d'impédance complexe à différentes températures. La microstructure typique des électrodes est présentée sur la figure 6.

b) Encres aqueuses (invention) :

De manière analogue à la cellule symétrique élaborée à l'aide des encres organiques, une cellule possédant environ 30 micromètres de couche fonctionnelle (LSM/YSZ) et 15 micromètres de couche collectrice (LSM) est élaborée à l'aide des encres aqueuses ayant une composition selon le tableau 4.

Tableau 4 : Composition des encres aqueuses à base de LSM (invention)

| Référence de l'encre | %vol. charge minérale | % vol. eau | %vol. PVA | %vol. PEG | % pds citrate d'ammonium/ charge minérale | Viscosités[i] (Pa.s) |
|---|---|---|---|---|---|---|
| LSM/YSZ 50/50% pds | 19,8% | 46,2% | 29,7% | 4% | 0,3% | 2,5 |
| LSM | 20,2% | 45,8% | 29,7% | 4% | 0,3% | 3,5 |
| [i] Viscosité mesurée au cisaillement de l'impression (250s$^{-1}$) (figure 7) | | | | | | |

Cette cellule dite « symétrique » est calcinée à 1.050°C pendant 3 heures sous air et caractérisée par spectroscopie d'impédance complexe à différentes températures. La microstructure typique des électrodes est présentée sur la figure 8.

c) Caractéristiques électrochimiques des électrodes.

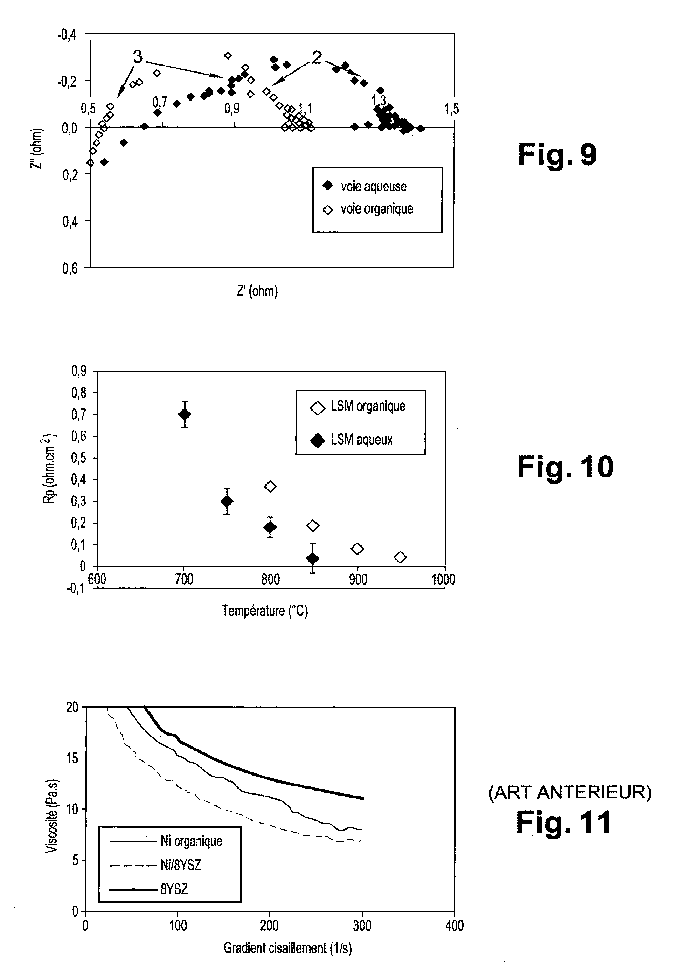

Les spectres d'impédance obtenus à partir des électrodes à base de LSM élaborées respectivement à l'aide d'encres organiques et aqueuses sont comparés sur la figure 9 alors que les valeurs des résistances de polarisation obtenues en fonction de la température sur ces deux types d'électrodes sont illustrées par la figure 10.

Ces résultats montrent qu'il est possible à partir d'encres aqueuses de reproduire l'architecture des électrodes élaborées à partir d'encres organiques avec une meilleure dispersion des particules qui se traduit par des performances électrochimiques (résistance de polarisation) améliorées.

Exemple 2 : Electrode composite à hydrogène à base de NiO/YSZ.

a) Encres organiques (art antérieur) :

Une cellule dite symétrique est préparée à l'aide de trois encres organiques ayant une composition selon le tableau 5.

Tableau 5 : Composition des encres organiques à base de YSZ et NiO (art antérieur).

| Référence de l'encre | %vol. charge minérale | %vol. terpinéol | %vol. éthyle cellulose | Viscosité [i] (Pa.s) |
|---|---|---|---|---|
| YSZ | 20% | 76,7% | 3,3% | 12,5 |
| YSZ/NiO 50/50% pds | 19,0% | 77,7% | 3,3% | 8,5 |
| NiO | 19,3% | 77,4% | 3,3% | 7 |
| [i] Viscosité mesurée au cisaillement de l'impression (250s$^{-1}$) (figure 11) | | | | |

L'encre à base YSZ est déposée de manière symétrique (2 faces) sur un électrolyte dense de YSZ avec une épaisseur de 5 micromètres par sérigraphie en vue d'élaborer la couche d'accroche de l'électrode nécessaire à la bonne adhérence entre la couche fonctionnelle et l'électrolyte.

La couche fonctionnelle à base d'un mélange YSZ/NiO (50/50% pds) est déposée de la même manière sur les couches d'accroche avec une épaisseur de 20 micromètres, puis la couche collectrice de 10 micromètres à base de NiO est ajoutée.

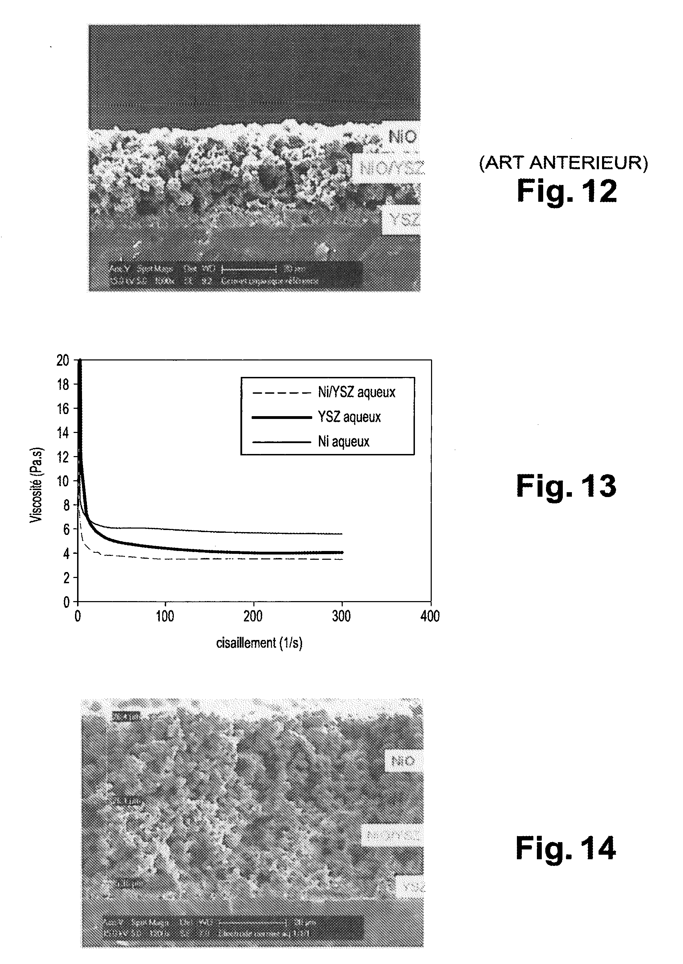

Cette cellule dite « symétrique » est calcinée à 1.200°C pendant 3 heures sous air et caractérisée par spectroscopie d'impédance complexe à différentes températures. La microstructure typique des électrodes est présentée sur la figure 12.

b) Encres aqueuses (invention) :

De manière analogue à la cellule symétrique élaborée à l'aide des encres organiques, une cellule possédant environ 5 micromètres de couche d'accroche (YSZ), 25 micromètres de couche fonctionnelle (NiO/YSZ) et 25 micromètres de couche collectrice (NiO) est élaborée à l'aide des encres aqueuses ayant une composition selon le tableau 6.

Tableau 6 : Composition des encres aqueuses à base de YSZ et NiO (invention)

| Référence de l'encre | %vol. charge minérale | %vol. eau | %vol. PVA | %vol. PEG | % pds citrate d'ammonium/ charge minérale | Viscosité [i] (Pa.s) |
|---|---|---|---|---|---|---|
| YSZ | 20,5% | 45,5% | 31,7% | 2% | 0,3% | 4 |
| YSZ/NiO 50/50% pds | 19,5% | 45,0% | 33,2% | 2% | 0,3% | 3,7 |
| NiO | 22% | 44% | 30,7% | 3% | 0,3% | 5,9 |
| [i] Viscosité mesurée au cisaillement de l'impression ($250s^{-1}$) (figure 13) | | | | | | |

Cette cellule dite « symétrique » est calcinée à 1.200°C pendant 3 heures sous air et caractérisée par spectroscopie d'impédance complexe à différentes températures. La microstructure typique des électrodes est présentée sur la figure 14.

c) Caractéristiques électrochimiques des électrodes.

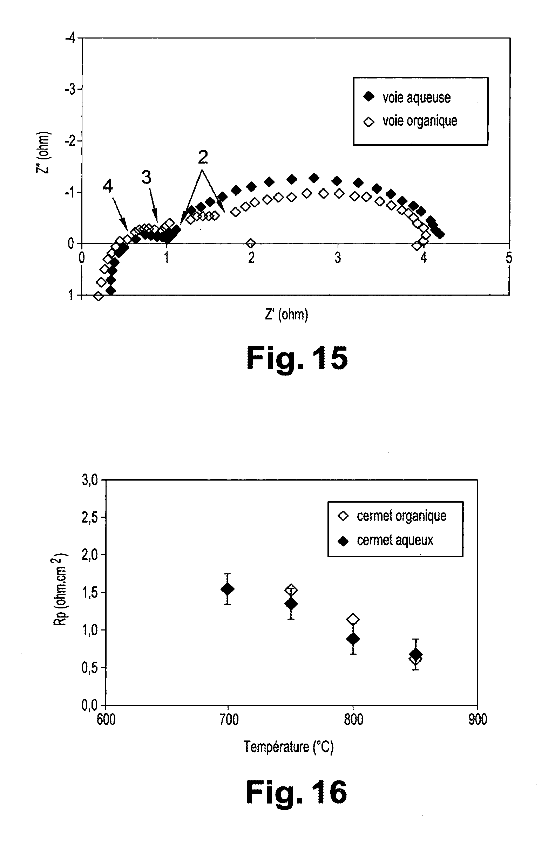

La figure 15 montre la comparaison des spectres d'impédance obtenus à partir des électrodes à hydrogène à base de YSZ et NiO élaborées respectivement à l'aide d'encres organiques et aqueuses. La figure 16 montre les valeurs des résistances de polarisation obtenues en fonction de la température sur ces deux types d'électrodes.

Ces résultats montrent qu'il est possible à partir d'encres aqueuses de reproduire l'architecture des électrodes élaborées à partir d'encres organiques avec une meilleure dispersion des particules qui se traduit par des performances électrochimiques (résistance de polarisation) améliorées.

**Revendications**

1. Encre aqueuse pour électrodes et/ou électrolyte de cellule électrochimique haute température, ladite encre comprenant :

   - des particules d'au moins une charge minérale,
   - au moins un liant, et
   - au moins un dispersant choisi dans le groupe comprenant l'acide chlorhydrique, l'acide sulfurique, ou des polyélectrolytes telles que le citrate d'ammonium et les carboxylates d'ammonium.

2. Encre aqueuse selon la revendication 1, *caractérisée* **en ce que** la charge minérale est choisie dans le groupe comprenant les oxydes des métaux de transition et de terres rares, et leurs mélanges, tels que LSM (manganite de lanthane dopée au strontium), YSZ (zircone stabilisée à l'oxyde d'yttrium), NiO (oxyde de nickel), CYO (cérine substituée à l'oxyde d'yttrium), CGO (cérine substituée à l'oxyde de gadolinium), le mélange LSM/YSM, le mélange YSZ/NiO, et leurs mélanges.

3. Encre aqueuse selon la revendication 1 ou 2, *caractérisée en ce que* le liant est choisi dans le groupe comprenant PVA (alcool polyvinylique), PEG (polyéthylène glycol), les polyacrylates, les celluloses, de manière générale tous les polymères solubles dans l'eau, et leurs mélanges, plus avantageusement, le liant est un mélange PVA/PEG.

4. Encre aqueuse selon l'une des revendications précédentes, *caractérisée en ce que* 50 % des particules de charge minérale ont un diamètre inférieur à 10 micromètres et 90 % desdites particules présentent un diamètre inférieur à 50 micromètres, plus avantageusement, 50 % des particules ont un diamètre inférieur à 1 micromètre et 90 % desdites particules présentent un diamètre inférieur à 2 micromètres.

5. Encre aqueuse selon l'une des revendications précédentes, *caractérisée en ce que* la viscosité de l'encre est comprise entre 1 et 60 Pa.s au cisaillement d'impression.

6. Encre aqueuse selon l'une des revendications précédentes, *caractérisée en ce que* la charge minérale représente de 10 à 30 % en volume par rapport au volume de l'encre aqueuse, plus avantageusement de 15 à 25 %vol.

7. Encre aqueuse selon l'une des revendications précédentes, *caractérisée en ce que* le liant représente de 20 à 50% en volume par rapport au volume de l'encre aqueuse, plus avantageusement de 25 à 35 %vol.

8. Encre aqueuse selon la revendication 3, *caractérisée en ce que* le mélange PVA/PEG est tel que le PVA représente 80 à 100% en poids du poids du mélange PVA/PEG, et plus avantageusement 95 à 99%.

9. Utilisation de l'encre aqueuse selon l'une des revendications précédentes pour la fabrication d'un électrolyte ou d'une électrode.

10. Procédé de réalisation d'une électrode de cellule électrochimique comprenant les étapes suivantes :

   - dépôt d'une première encre aqueuse selon l'une des revendications 1 à 8, avantageusement par sérigraphie, de manière à former la couche fonctionnelle ;
   - dans le cas d'électrode contenant du NiO, dépôt d'une couche dite d'accroche à base du matériau d'électrolyte ;
   - dépôt d'une deuxième encre aqueuse selon l'une des revendications 1 à 9, avantageusement par sérigraphie, sur la couche fonctionnelle, de manière à former la couche collectrice ;
   - frittage de l'électrode.

11. Electrode obtenue selon le procédé de la revendication 10.

12. Electrode selon la revendication 11, *caractérisée en ce que* ladite électrode est une électrode à air ou à hydrogène.

13. Procédé de réalisation d'un électrolyte de cellule électrochimique comprenant le dépôt de l'encre aqueuse selon l'une des revendications 1 à 8, avantageusement par sérigraphie.

14. Electrolyte obtenu selon le procédé de la revendication 13.

15. Cellule électrochimique comprenant au moins une électrode selon la revendication 11 ou 12 et/ou un électrolyte selon la revendication 14.

**Patentansprüche**

1. Wässrige Tinte für Elektroden und/oder einen Elektrolyten einer elektrochemischen Hochtemperaturzelle, wobei die Tinte umfasst:

   - Partikel mindestens eines mineralischen Füllstoffs,
   - mindestens ein Bindemittel,
   - mindestens ein Dispersionsmittel, das aus der Gruppe ausgewählt ist, die Salzsäure, Schwefelsäure oder Polyelektrolyte wie etwa Ammoniumcitrat und Ammoniumcarboxylate umfasst.

2. Wässrige Tinte nach Anspruch 1, **dadurch gekennzeichnet, dass** der mineralische Füllstoff aus der Gruppe ausgewählt ist, die Übergangsmetall- und Seltenerdmetalloxide und deren Gemische wie etwa LSM (strontiumdotiertes Lanthanmanganit), YSZ (mit Yttriumoxid stabilisiertes Zirkon), NiO (Nickeloxid), CYO (mit Yttriumoxid substituiertes Cerin), CGO (mit Gadolinium substituiertes Cerin), LSM/YSM-Mischung, YSZ/NiO-Mischung und deren Gemische umfasst.

3. Wässrige Tinte nach Anspruch 1 oder 2, **dadurch gekennzeichnet, dass** das Bindemittel aus der Gruppe ausgewählt ist, die PVA (Polyvinylalkohol), PEG (Polyethylenglycol), Polyacrylate, Cellulosen, allgemein alle wasserlöslichen Polymere und deren Gemische umfasst, wobei das Bindemittel vorteilhafterer Weise eine PVA/PEG-Mischung ist.

4. Wässrige Tinte nach einem der vorhergehenden Ansprüche, **dadurch gekennzeichnet, dass** 50% der Partikel des mineralischen Füllstoffs einen Durchmesser von unter 10 Mikrometer haben und 90% dieser Partikel einen Durchmesser von unter 50 Mikrometer aufweisen, vorteilhafterer Weise 50% der Partikel einen Durchmesser von unter 1 Mikrometer haben und 90% dieser Partikel einen Durchmesser von unter 2 Mikrometer aufweisen.

5. Wässrige Tinte nach einem der vorhergehenden Ansprüche, **dadurch gekennzeichnet, dass** die Viskosität der Tinte zwischen 1 und 60 Pa.s bei Druckabscherung beträgt.

6. Wässrige Tinte nach einem der vorhergehenden Ansprüche, **dadurch gekennzeichnet, dass** der mineralische Füllstoff 10 bis 30 Volumen-% im Verhältnis zum Volumen der wässrigen Tinte, vorteilhafterer Weise 15 bis 25 Vol.-% darstellt.

7. Wässrige Tinte nach einem der vorhergehenden Ansprüche, **dadurch gekennzeichnet, dass** das Bindemittel 20 bis 50 Volumen-% im Verhältnis zum Volumen der wässrigen Tinte, vorteilhafterer Weise 25 bis 35 Vol.-% darstellt.

8. Wässrige Tinte nach Anspruch 3, **dadurch gekennzeichnet, dass** die PVA/PEG-Mischung dergestalt ist, dass der PVA 80 bis 100 Gew.-% des Gewichts der PVA/PEG-Mischung, vorteilhafterer Weise 95 bis 99% darstellt.

9. Verwendung der wässrigen Tinte nach einem der vorhergehenden Ansprüche zur Herstellung eines Elektrolyten oder einer Elektrode.

10. Verfahren zur Herstellung einer Elektrode einer elektrochemischen Zelle, die folgenden Schritte umfassend:

- Auftragen einer ersten wässrigen Tinte nach einem der Ansprüche 1 bis 8, vorteilhafter Weise durch Siebdruck, um die Funktionsschicht zu bilden;
- im Falle einer NiO enthaltenden Elektrode, Auftragen einer Schicht, aftschicht genannt, auf Basis des Elektrolytmaterials;
- Auftragen einer zweiten wässrigen Tinte nach einem der Ansprüche 1 bis 9, vorteilhafter Weise durch Siebdruck, auf die Funktionsschicht, um die Kollektorschicht zu bilden;
- Sintern der Elektrode.

11. Elektrode, die nach dem Verfahren des Anspruchs 10 erhalten ist.

12. Elektrode nach Anspruch 11, **dadurch gekennzeichnet, dass** die Elektrode eine Luft- oder Wasserstoffelektrode ist.

13. Verfahren zur Herstellung eines Elektrolyten einer elektrochemischen Zelle, das Auftragen der wässrigen Tinte nach einem der Ansprüche 1 bis 8, vorteilhafter Weise durch Siebdruck umfassend.

14. Elektrolyt, der nach dem Verfahren von Anspruch 13 erhalten ist.

15. Elektrochemische Zelle, mindestens eine Elektrode nach Anspruch 11 oder 12 und/oder einen Elektrolyten nach Anspruch 14 umfassend.

**Claims**

1. An aqueous ink for high-temperature electrochemical cell electrodes and/or electrolyte, said ink comprising:

- particles of at least one mineral filler,

- at least one binder, and
- at least one dispersant selected from the group comprising hydrochloric acid, sulfuric acid, or polyelectrodes such as ammonium citrate and ammonium carboxylates.

2. The aqueous ink of claim 1, wherein the mineral filler is selected from the group comprising oxides of transition metals and of rare earths, and mixtures thereof, such as LSM (lanthanum strontium manganite), YSZ (yttria-stabilized zirconia), NiO (nickel oxide), CYO (yttrium-substituted cerium oxide), CGO (gadolinium-substituted cerium oxide), the LSM/YSM mixture, the YSZ/NiO mixture, and mixtures thereof.

3. The aqueous ink of claim 1 or 2, wherein the binder is selected from the group comprising PVA (polyvinyl alcohol), PEG (polyethylene glycol), polyacrylates, celluloses, generally all polymers soluble in water, and the mixtures thereof, more advantageously, the binder is a PVA/PEG mixture.

4. The aqueous ink of any of the foregoing claims, wherein 50 % of the mineral filler particles have a diameter smaller than 10 micrometers and 90 % of said particles have a diameter smaller than 50 micrometers, more advantageously, 50 % of the particles have a diameter smaller than 1 micrometer and 90 % of said particles have a diameter smaller than 2 micrometers.

5. The aqueous ink of any of the foregoing claims, wherein the ink viscosity ranges between 1 and 60 Pa.s at the printing shearing.

6. The aqueous ink of any of the foregoing claims, wherein the mineral filler amounts to from 10 to 30% by volume with respect to the aqueous ink volume, more advantageously from 15 to 25% by volume.

7. The aqueous ink of any of the foregoing claims, wherein the binder amounts to from 20 to 50% by volume with respect to the aqueous ink volume, more advantageously from 25 to 35% by volume.

8. The aqueous ink of claim 3, wherein the PVA/PEG mixture is such that PVA amounts to from 80 to 100% by weight of the weight of the PVA/PEG mixture, and more advantageously from 95 to 99%.

9. A use of the aqueous ink of any of the foregoing claims to manufacture an electrolyte or an electrode.

10. A method for manufacturing an electrochemical cell electrode comprising the steps of:

- depositing a first aqueous ink of any of claims 1 to 8, advantageously by screen printing, to form the functional layer;
- in the case of an electrode containing NiO, depositing a so-called bonding layer containing the electrolyte material;
- depositing a second aqueous ink of any of claims 1 to 9, advantageously by screen printing, on the functional layer, to form the collector layer;
- sintering the electrode.

11. An electrode obtained according to the method of claim 10.

12. The electrode of claim 11, wherein said electrode is an air or hydrogen electrode.

13. A method for forming an electrochemical cell electrolyte comprising depositing the aqueous ink of any of claims 1 to 8, advantageously by screen printing.

14. An electrolyte obtained according to the method of claim 13.

15. An electrochemical cell comprising at least one electrode of claim 11 or 12 and/or an electrolyte of claim 14.

(ART ANTERIEUR)

## Fig. 1

## Fig. 2

## Fig. 3

Rs: Résistance ohmique

Rp: Résistance de polarisation

(ART ANTERIEUR)
**Fig. 4**

(ART ANTERIEUR)
**Fig. 5**

(ART ANTERIEUR)
**Fig. 6**

**Fig. 7**

**Fig. 8**

**Fig. 9**

**Fig. 10**

(ART ANTERIEUR)
**Fig. 11**

(ART ANTERIEUR)
**Fig. 12**

**Fig. 13**

**Fig. 14**

**Fig. 15**

**Fig. 16**

**EP 2 616 516 B1**

## RÉFÉRENCES CITÉES DANS LA DESCRIPTION

**Documents brevets cités dans la description**

- WO 2006066973 A

**Littérature non-brevet citée dans la description**

- **HUIJSMANS et al.** *Fuel Cells Bulletin,* Novembre 1999, vol. 2 (14), 5-7